# FASCICULE DE BREVET EUROPEEN

(11) **EP 2 954 560 B1**
(45) Date de publication et mention de la délivrance du brevet: **04.01.2017**
(21) Numéro de dépôt: 14706886.0
(22) Date de dépôt: 04.02.2014
(51) Int. Cl.: H01L 31/048

(54) **UTILISATION D'UNE COMPOSITION POLYMERIQUE FLUIDE POUR L'ENCAPSULATION DE MODULES PHOTOVOLTAÏQUES**
VERWENDUNG EINER FLUIDISCHEN POLYMERZUSAMMENSETZUNG ZUR VERKAPSELUNG VON PHOTOVOLTAIKMODULEN
USE OF A FLUID POLYMERIC COMPOSITION FOR ENCAPSULATING PHOTOVOLTAIC MODULES

(30) Priorité: 06.02.2013 FR 1351014
(43) Date de publication de la demande: 16.12.2015
(73) Titulaire: Arkema France, 92700 Colombes (FR)
(72) Inventeur: DEVISME, Samuel, F-76000 Rouen (FR); CORFIAS-ZUCCALLI, Catherine, F-69100 Villeurbanne (FR); CAMINADE, Sophie, F-93400 Saint Ouen (FR); LAURICHESSE, Christian, F-64140 Lons (FR)
(74) Mandataire: Gavin, Pablo
(86) Numéro de dépôt international: PCT/FR2014/050207
(87) Numéro de publication internationale: WO 2014/122392

(56) Documents cités:
- WO-A1-2005/006451
- JP-B2- 3 163 807

## Description

### DOMAINE TECHNIQUE DE L'INVENTION

L'invention s'inscrit dans le domaine de la fabrication de modules photovoltaïques. Plus particulièrement, elle concerne l'utilisation d'une composition polymérique fluide pour l'encapsulation des modules photovoltaïques.

### ART ANTERIEUR

Le photovoltaïque est une technologie de production d'énergie en plein essor, qui présente l'avantage de ne pas émettre de gaz à effet de serre, à la différence des énergies fossiles, et dont le combustible, la lumière, est inépuisable. En plus d'être écologique, le photovoltaïque est pratique car un module photovoltaïque permet d'alimenter en électricité une habitation isolée ou des dispositifs qui ne peuvent pas être raccordés au circuit électrique, tels que des téléphones portables, des horodateurs, des Abribus, etc.

Un module photovoltaïque, ou panneau solaire, est un générateur électrique permettant de transformer l'énergie solaire en courant continu. Il est généralement constitué d'un ensemble de cellules photovoltaïques à base d'un matériau semi-conducteur tel que le silicium, reliées entre elles électriquement en série et/ou en parallèle.

Il est connu d'encapsuler cet ensemble de cellules photovoltaïques dans un matériau désigné habituellement par le terme « encapsulant ». L'encapsulant comprend généralement une partie supérieure et une partie inférieure, les cellules photovoltaïques étant bloquées entre ces deux parties. Pour compléter le module photovoltaïque, une couche protectrice avant et une couche protectrice arrière (ou « backsheet » en anglais) sont disposées contre chaque face de l'encapsulant. Le rôle de l'encapsulant consiste à maintenir les cellules liées, à les isoler électriquement et à les protéger de l'environnement extérieur, en particulier de l'eau et de l'air.

L'encapsulant est généralement à base de copolymère éthylène/acétate de vinyle (EVA) comme cela a été décrit dans la demande de brevet JP 19870174967, qui constitue la solution technique la plus répandue actuellement. La composition polymérique servant d'encapsulant se présente sous la forme d'un film d'une épaisseur comprise entre typiquement 50 µm et 20 mm. Le film peut être monocouche ou multicouche.

Dans un procédé classique de fabrication d'un module photovoltaïque, plusieurs étapes sont nécessaires pour l'encapsulation des cellules.

Dans une toute première étape, la composition polymérique servant d'encapsulant est préparée par copolymérisation, typiquement par copolymérisation radicalaire.

Puis cette composition polymérique est mélangée à des additifs en utilisant des techniques connues de mélange des matériaux thermoplastiques telles que l'extrusion ou le malaxage. Les additifs classiquement ajoutés à la composition polymérique sont des peroxydes à activation thermique pour réticuler la composition polymérique, des silanes pour améliorer les propriétés adhésives et des agents anti-UV pour améliorer la résistance aux UV.

Le mélange obtenu est alors mis en forme sous la forme d'un film en utilisant des techniques connues telles que le pressage, l'extrusion-soufflage de gaine, l'extrusion-laminage, l'extrusion-couchage, l'extrusion à plat et le calandrage.

Les cellules photovoltaïques sont ensuite encapsulées dans le film polymère. Typiquement, on place successivement une couche protectrice arrière, une première couche de film polymère encapsulant, les cellules photovoltaïques, une seconde couche de film polymère encapsulant, puis enfin une couche protectrice avant. Les couches sont assemblées par des techniques de pressage associées à un traitement thermique, telles que le pressage à chaud, le pressage sous vide et le laminage à chaud. Lorsque la température atteint le point de fusion de la composition polymérique, celle-ci s'écoule tout autour de l'ensemble des cellules photovoltaïques. Puis, lorsque la température atteint la température d'activation de l'agent de réticulation (typiquement vers 150°C), la composition polymérique se réticule, ce qui permet d'obtenir un ensemble compact, lié très fortement et de façon irréversible.

La fabrication de modules photovoltaïques à l'aide de films de composition polymérique est par exemple décrite dans la demande internationale de brevet WO 2010/067040. D'autres éléments concernant la fabrication des modules photovoltaïques peuvent être trouvés par exemple dans l'ouvrage « Handbook of Photovoltaic Science and Engineering », Wiley, 2003.

Ce procédé de fabrication de modules photovoltaïques, qui constitue actuellement le procédé de fabrication le plus répandu, permet d'obtenir des modules photovoltaïques aux propriétés satisfaisantes : bonne adhésion des différentes couches, peu de délaminage des différentes couches, résistance à l'abrasion et aux chocs, étanchéité à l'eau et à l'oxygène de l'air... Cependant, ce procédé présente l'inconvénient majeur de nécessiter au moins quatre étapes successives (copolymérisation, mélange avec des additifs, mise en forme sous forme de film et pressage avec traitement thermique). Chacune de ces étapes nécessite un matériel spécifique. Le procédé complet de préparation est donc long et coûteux. En outre, la dernière étape de pressage avec traitement thermique est une étape de traitement qui ne peut se faire que par lot (appelé procédé « batch » selon la terminologie anglo-saxonne). L'homme du métier ne dispose pas pour le moment de méthode permettant la fabrication de modules photovoltaïques en continu.

Il existe donc actuellement un besoin de disposer d'un procédé de fabrication de modules photovoltaïques plus court, comprenant moins d'étapes, plus rapide à mettre en oeuvre et moins coûteux. De plus, il existe aussi le besoin de disposer d'un procédé continu de fabrication de modules photovoltaïques.

### RESUME DE L'INVENTION

L'invention a pour objet l'utilisation comme encapsulant dans un module photovoltaïque d'une composition polymérique, ladite composition polymérique comprenant un copolymère qui comprend un monomère d'éthylène et un comonomère d'ester vinylique d'acide carboxylique, le comonomère d'ester vinylique d'acide carboxylique représentant entre 5% et 50% en poids, par rapport au poids total du copolymère, et la composition polymérique ayant une viscosité Brookfield mesurée à 120°C comprise entre 10 000 mPa.s et 25 000 mPa.s.

### DESCRIPTION DETAILLEE

Il est précisé que, dans toute cette description, l'expression « compris(e) entre » doit s'entendre comme incluant les bornes citées.

La composition polymérique utilisée selon l'invention comprend un copolymère. Ledit copolymère comprend au moins un monomère d'éthylène et au moins un comonomère d'ester vinylique d'acide carboxylique. Le copolymère peut éventuellement comprendre d'autre (s) comonomère(s).

De préférence, le comonomère d'ester vinylique d'acide carboxylique peut être choisi dans le groupe constitué par l'acétate de vinyle, le 2-éthylhexanoate de vinyle (V2EH), l'octanoate de vinyle et l'ester vinylique de l'acide versatique. Parmi ces comonomères, l'acétate de vinyle est préféré. Le copolymère est donc dans ce cas un copolymère éthylène / acétate de vinyle.

Le copolymère comprend de 5% à 50%, préférentiellement de 10% à 40%, plus préférentiellement de 15% à 35% en poids de comonomère d'ester vinylique d'acide carboxylique, par rapport au poids total du copolymère.

Par ailleurs, le copolymère peut comprendre de 50% à 95%, préférentiellement de 60% à 90%, plus préférentiellement de 65% à 85% en poids de monomère d'éthylène, par rapport au poids total du copolymère.

Les quantités des différents comonomères présents dans le copolymère peuvent être mesurées par spectroscopie infrarouge en utilisant la norme ISO 8985 (1998).

Préférentiellement, le copolymère est constitué d'un monomère d'éthylène et d'un comonomère d'ester vinylique d'acide carboxylique. Toutefois, il est également possible que le copolymère comprenne un ou plusieurs autres comonomères pouvant être choisis parmi les acrylates et les méthacrylates d'alkyle et d'hydroxy-alkyle, tels que l'acrylate de méthyle, le méthacrylate de méthyle, l'acrylate d'éthyle, le méthacrylate d'éthyle, l'acrylate de butyle, le méthacrylate de butyle, l'acrylate d'hydroxy-éthyle, le méthacrylate d'hydroxy-éthyle, l'acrylate de 2-éthylhexyle, le méthacrylate de 2-éthylhexyle, l'acrylate de propyle, le méthacrylate de propyle, l'acrylate d'isopropyle, le méthacrylate d'isopropyle, l'acrylate de n-butyle, le méthacrylate de n-butyle, l'acrylate d'isobutyle, le méthacrylate d'isobutyle, l'acrylate de tert-butyle, le méthacrylate de tert-butyle, l'acrylate de n-pentyle, le méthacrylate de n-pentyle, l'acrylate de néopentyle, le méthacrylate de néopentyle, l'acrylate d'hexyle, le méthacrylate d'hexyle, l'acrylate d'heptyle, le méthacrylate d'heptyle, l'acrylate d'octyle, le méthacrylate d'octyle, l'acrylate de néooctyle, le méthacrylate de néooctyle, l'acrylate de nonyle, le méthacrylate de nonyle, l'acrylate de néononyle, le méthacrylate de néononyle, l'acrylate de décyle, le méthacrylate de décyle, l'acrylate de néodécyle, le méthacrylate de néodécyle, l'acrylate de lauryle, le méthacrylate de lauryle, l'acrylate de palmityle, le méthacrylate de palmityle, l'acrylate de stéaryle ou le méthacrylate de stéaryle. Le poids total d'un ou plusieurs autres comonomères, par rapport au poids total du copolymère, peut être compris entre 0% et 20%, préférentiellement entre 5% et 15%, plus préférentiellement entre 5% et 10%.

Le copolymère selon l'invention peut être obtenu par polymérisation selon le procédé indiqué ci-après :
Le copolymère peut être préparé par un procédé de polymérisation radicalaire sous haute pression. La polymérisation peut être effectuée par exemple dans un réacteur autoclave agité ou tubulaire. La pression à l'intérieur du réacteur peut être comprise entre 1 000 bars et 3 000 bars, préférentiellement entre 1 500 bars et 2 500 bars. La température lors de l'amorçage de la réaction peut être comprise entre 100°C et 300°C, avantageusement entre 100°C et 170°C. La température maximale de réaction peut être comprise entre 180°C et 300°C et de manière préférée entre 200°C et 280°C.

La copolymérisation peut être effectuée en introduisant le monomère d'éthylène, le comonomère d'ester vinylique d'acide carboxylique et un amorceur de polymérisation à pression élevée dans un réacteur autoclave ou tubulaire à une température initiale. Lorsqu'un réacteur tubulaire est utilisé, de préférence, l'introduction du mélange du monomère d'éthylène, du comonomère d'ester vinylique d'acide carboxylique et de l'amorceur de polymérisation est effectuée en entrée du réacteur tubulaire, et éventuellement en au moins un autre point d'injection situé le long du réacteur tubulaire. On parle alors de technique d'injection multipoint.

Les quantités des comonomères introduits sont ajustées en fonction de la teneur finale désirée dans le copolymère.

La quantité d'amorceur peut varier entre 10 ppm et 1000 ppm en poids, préférentiellement entre 10 ppm et 800 ppm, plus préférentiellement entre 10 ppm et 500 ppm, par rapport aux monomères introduits.

Comme amorceur de polymérisation, tous les composés organiques et inorganiques qui libèrent des radicaux libres dans les conditions de la réaction peuvent être utilisés. De préférence, on peut utiliser un composé ou des mélanges de composés comprenant au moins un groupement peroxyde. L'amorceur de polymérisation peut être préférentiellement choisi dans le groupe constitué des peroxyesters, des diacyls, des percarbonates, des peroxykétals, des dialkyls, des hydroperoxydes et les mélanges de ceux-ci. Avantageusement, l'amorceur de polymérisation peut être choisi dans le groupe constitué par les tert-butyl peroxyesters dont le groupe ester renferme de 5 à 10 atomes de carbones, tels que le tert-butyl peroxynéodécanoate, le tert-butyl peroxy-2-éthyl hexanoate, le tert-butylperoxy-3,5,5-triméthylhexanoate et le tert-butyl peroxypivalate, ou il peut s'agir du di-ter-butylperoxide. Ces peroxydes sont particulièrement bien adaptés à la réaction de copolymérisation décrite ici.

En plus des monomères et de l'amorceur, on peut avantageusement utiliser un agent de transfert dans des proportions par rapport à la quantité totale de monomères en poids, comprises entre 0% et 4%, préférentiellement comprises entre 0,1% et 3% , plus préférentiellement comprises entre 0,3% et 0,6%. Ces agents de transfert permettent de contrôler les masses moléculaires du copolymère formé. L'agent de transfert peut être choisi parmi des aldéhydes ou des cétones aliphatiques. Il est de préférence choisi parmi le propanaldéhyde et la MEK (méthyl-éthyl-cétone).

De façon générale, les quantités d'amorceur et d'agent de transfert sont ajustées de façon à obtenir un copolymère ayant la viscosité Brookfield souhaitée de 10 000 à 25 000 mPa.s à 120°C, ce qui peut correspondre à une masse moléculaire moyenne en nombre (Mn) comprise entre 6 000 et 12 000 et à une masse moléculaire moyenne en poids (Mw) comprise entre 20 000 g/mol et 60 000 g/mol.

A l'issue de la copolymérisation, une quantité résiduelle inférieure à 700 ppm de l'agent de transfert peut se trouver dans le copolymère final. L'initiateur est quant à lui décomposé totalement.

La composition polymérique utilisée selon l'invention comprend le copolymère tel que décrit ci-avant. Le copolymère peut représenter entre 92% et 99,9%, préférentiellement entre 97,5% et 99,5%, par rapport au poids total de la composition polymérique. En outre, la composition polymérique peut comprendre d'autres composés, que l'on désigne de façon générale par le terme « additifs ». Ces additifs peuvent représenter au total entre 0,1% et 10%, préférentiellement entre 0,5% et 3,5% par rapport au poids total de la composition polymérique.

Le ou les additifs pouvant être compris dans la composition polymérique peuvent être choisis parmi ceux connus de l'homme du métier comme additifs présents dans les compositions polymériques sous forme de film servant d'encapsulant.

Tout particulièrement, la composition polymérique selon l'invention peut comprendre un agent de réticulation. L'agent de réticulation a pour fonction de réticuler le copolymère présent dans la composition polymérique après dépôt de celle-ci sur les cellules photovoltaïques. La réticulation permet d'améliorer les propriétés thermomécaniques de l'encapsulant, en particulier à haute température. L'agent de réticulation peut être choisi parmi les agents de réticulation à activation thermique, à activation par irradiation ou autres. De façon préférée, l'agent de réticulation est un agent de réticulation à activation thermique, préférentiellement un peroxyde. Avantageusement, l'agent de réticulation est choisi dans le groupe constitué par le monoperoxycarbonate de O,O-tertiobutyle et de O-(2-éthylhexyle), le peroxycarbonate de O-(2-éthylhexyl) et de O,O-tertiopentyle, l'hydroperoxyde de tertiobutyle, le 2,5-diméthyl-2,5-di(tertiobutylperoxy)hexane, l'éthyl-2 peroxyhexanoate de tertiobutyle, et le 1-1 di(tert-butylperoxy) 3,3,5-triméthylcyclohexane.

L'agent de réticulation peut représenter au total entre 0,1% et 5%, préférentiellement entre 0,5% et 2,5%, plus préférentiellement entre 0,7% et 2% en poids, par rapport au poids total de la composition polymérique.

Par ailleurs, la composition polymérique selon l'invention peut comprendre un co-agent de réticulation. Les co-agents de réticulation permettent avantageusement d'accélérer la vitesse de réticulation et/ou d'optimiser le taux de réticulation atteint. Le co-agent de réticulation peut être en particulier choisi parmi des monomères multifonctionnels, porteurs d'au moins 2 fonctions vinyliques. On peut citer pour exemples l'isocyanurate de triallyle ou le cyanate de triallyle.

En outre, la composition polymérique selon l'invention peut comprendre un agent de couplage. Les agents de couplage permettent avantageusement d'améliorer l'adhésion entre la composition polymérique et les autres éléments du module photovoltaïque. L'agent de couplage peut être en particulier choisi parmi des titanates organiques ou des silanes. Avantageusement, l'agent de couplage est choisi dans le groupe constitué par les silanes, comme par exemple le méthacrylate de 3-triméthoxysilyl propyle ou le vinyl triméthoxysilane.

De plus, la composition polymérique selon l'invention peut comprendre un agent absorbeur d'UV. Ces agents sont connus pour prolonger la durée de vie du module photovoltaïque en évitant les dommages que les UV causent aux différents composants. L'agent absorbeur d'UV peut être en particulier choisi parmi les benzotriazoles ou les benzophénones.

La composition polymérique selon l'invention peut en outre comprendre un stabilisant UV à base d'amines à encombrement stérique (ou HALS pour « Hindered Amine Light Stabilizers ») et/ou un antioxydant. Ces additifs ont également pour rôle de prolonger la durée de vie du module photovoltaïque. Grâce à leurs propriétés antioxydantes, ils protègent les différents constituants du module des méfaits des radicaux qui peuvent se créer par exposition aux UV ou à la chaleur. Le HALS peut être en particulier choisi parmi le sebaçate de bis(2,2,6,6-tétraméthyl-4-pipéridyle), le poly[[6-[(1,1,3,3-tétra-méthylbutyl)amino]-1,3,5-triazine-2,4-diyl][(2,2,6,6-tétraméthyl-4-pipéridinyl)imino]-1,6-hexanediyl[(2,2,6,6-tétraméthyl-4-pipéridinyl)imino]]) ou encore le [[3,5-bis(1,1-diméthyléthyl)-4-hydroxyphényl]méthyl] butyl-malonate de bis(1,2,2,6,6-pentaméthyl-4-pipéridyle. L'antioxydant peut être en particulier choisi parmi le tétrakis-3(3,5-di-tert-butyl-4-hydroxyphényl) propionate de pentaérythritol, le 3-(3,5-di-tert-butyl-4-hydroxyphényl)propionate d'octadécyle ou le phosphite de tris(2,4-di-tert-butylphényle).

L'addition de ces différents additifs peut être réalisée par les méthodes connues de l'homme de l'art, telles que l'utilisation d'un fondoir ou d'un mélangeur interne ou par imprégnation dans le cas d'additifs sous forme liquide.

La composition polymérique qui est utilisée selon l'invention a une viscosité Brookfield mesurée à 120°C comprise entre 10 000 mPa.s et 25 000 mPa.s, et préférentiellement entre 12 000 mPa.s et 23 000 mPa.s.

Les mesures de viscosité ont été réalisées sur un viscosimètre Brookfield. La température de référence est prise à 120°C. Les mesures peuvent notamment être réalisées selon le mode opératoire suivant :
L'équipement utilisé est un Rhéomètre Brookfield RV-DVIII. Un mobile de géométrie cylindrique à extrémités coniques (type SC4-27 ou SC4-29 selon la gamme de viscosité étudiée) est plongé dans l'échantillon dont la température est régulée à 120°C. Le mobile est mis en rotation à la vitesse de 20 tours par minutes. La résistance appliquée par l'échantillon contre la rotation du mobile est mesurée et permet de calculer sa viscosité.

Grâce à ses propriétés physico-chimiques particulières, la composition polymérique selon l'invention peut être utilisée comme encapsulant dans un module photovoltaïque d'une façon tout à fait nouvelle.

En effet, grâce à sa viscosité relativement faible, la composition polymérique peut être coulée et peut être appliquée directement sur l'ensemble des cellules photovoltaïques. Il n'est donc plus nécessaire de mettre en forme la composition polymérique servant l'encapsulant sous la forme d'un film avant de l'utiliser.

La présente invention concerne donc également un procédé de fabrication de module photovoltaïque dans lequel une ou plusieurs cellules photovoltaïques sont encapsulées avec la composition polymérique décrite ci-dessus. L'invention a aussi pour objet un procédé particulier d'encapsulation d'un module photovoltaïque comprenant les étapes consistant à :
a) se munir d'une composition polymérique comprenant :
   - un copolymère comprenant un monomère d'éthylène et un comonomère d'ester vinylique d'acide carboxylique, le comonomère d'ester vinylique d'acide carboxylique représentant entre 5 et 50% en poids, par rapport au poids total du copolymère, et
   - un agent de réticulation,
   la composition polymérique ayant une viscosité Brookfield mesurée à 120°C comprise entre 10 000 mPa.s et 25 000 mPa.s ;
b) former un empilement comprenant, dans l'ordre, une couche protectrice arrière, une première couche de la composition polymérique, un ensemble de cellules photovoltaïques, une seconde couche de la composition polymérique, et une couche protectrice avant ; puis
c) appliquer un traitement d'activation adapté à l'agent de réticulation pour réticuler la composition.

L'étape consistant à se munir de la composition polymérique peut comprendre les étapes consistant à synthétiser le copolymère convenable ou à se le procurer directement sous forme finie, puis à procéder à son mélange avec un agent de réticulation et éventuellement avec d'autres additifs. Ces différentes étapes, ainsi que les compositions mises en oeuvre, peuvent être telles que décrites ci-avant dans le présent texte. Alternativement, il est également possible de se procurer la composition polymérique comprenant le copolymère et l'agent de réticulation à activation thermique sous forme déjà mélangée.

Lors de l'étape de formation de l'empilement, les couches de la composition polymérique selon l'invention peuvent être déposées par tout moyen connu de l'homme du métier sans mise en forme préalable. La relative faible viscosité de la composition polymérique à l'état fondu permet d'utiliser des techniques connues notamment dans le domaine des peintures, par exemple à l'aide d'un rouleau, ou dans le domaine de la thermoenduction (ou « hot-melt » selon la terminologie anglo-saxonne), par exemple par enduction à l'aide d'un applicateur spiralé (ou « bar-coater » selon la terminologie anglo-saxonne).

Une fois l'empilement formé, un traitement d'activation adapté à l'agent d'activation est réalisé, de façon à réticuler la composition polymérique. Par exemple, dans le cas d'un agent de réticulation à activation thermique, cette étape peut consister à traiter thermiquement l'empilement à une température supérieure à la température d'activation de l'agent de réticulation de la composition polymérique.

Des compositions polymériques comprenant un copolymère éthylène / acétate de vinyle et présentant une viscosité Brookfield suffisamment faible pour être coulables sont déjà connues actuellement sous le nom d'Evazole® commercialisé par la société Arkema. Ces compositions sont classiquement utilisées comme additif dans les carburants

Cependant, les inventeurs ont découvert que, plus la viscosité de la composition polymérique était faible, plus il devenait difficile de réticuler de façon satisfaisante le copolymère, jusqu'à atteindre une viscosité critique en dessous de laquelle la composition polymérique n'était plus réticulable. Ainsi la gamme de produits Evazole® n'est pas applicable pour une application d'encapsulant photovoltaïque.

C'est donc de façon tout à fait surprenante que la composition polymérique décrite dans la présente invention présente à la fois une viscosité telle que la composition peut être appliquée directement telle une peinture, et une bonne réticulabilité.

Les modules photovoltaïques obtenus par le procédé tel que décrit ci-dessus présentent des propriétés au moins aussi satisfaisantes que les modules obtenus par un procédé classique d'encapsulation à l'aide d'un film d'encapsulant. En particulier, on a constaté que les différentes couches des modules obtenus selon le procédé de la présente invention avaient une bonne adhésion entre elles et que les modules ne présentaient pas de problèmes de délaminage.

Le procédé objet de la présente invention peut avantageusement être mis en oeuvre en continu. En effet, les étapes de formation de l'empilement et de traitement thermique peuvent être effectuées en continu selon des méthodes classiques.

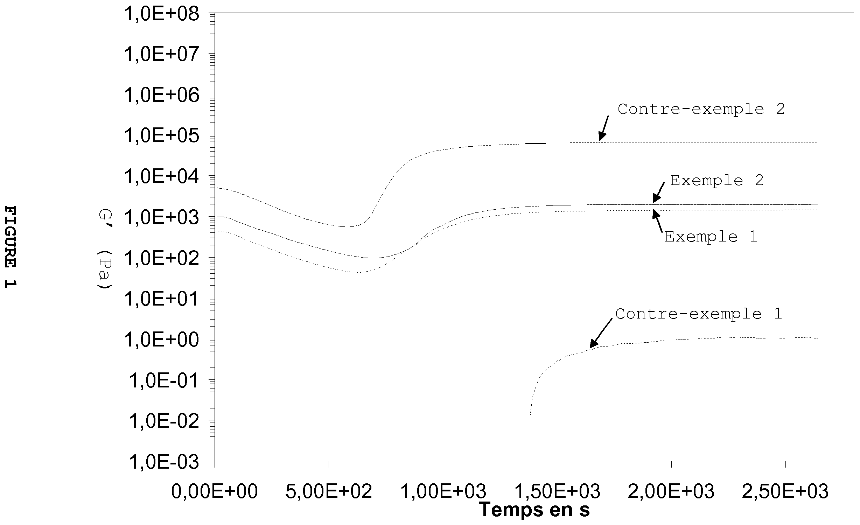

D'autres buts, caractéristiques et avantages de l'invention apparaîtront des exemples de réalisation suivants, qui sont donnés à titre purement illustratif et nullement limitatif, et qui se réfèrent à la figure 1 annexée qui est un graphe représentant les courbes d'évolution du module élastique G' (en Pa) des compositions exemplifiées en fonction du temps t (en s).

### EXEMPLES

### 1) Synthèse du copolymère / caractérisation de la viscosité Brookfield :

Dans les exemples 1 et 2, deux copolymères ont été synthétisés à partir des réactifs suivants :

| Essai | Acétate de vinyle (% en poids) | Agent de transfert injecté (% en poids) | Taux de peroxyde (ppm en poids) |
|---|---|---|---|
| Exemple 1 | 28 | 0,5 | 162 |
| Exemple 2 | 28 | 0,4 | 186 |

Un autre copolymère a été préparé dans des conditions permettant d'obtenir une viscosité Brookfield inférieure à 10 000 mPa.s. Il s'agit du contre-exemple 1.

| Essai | Acétate de vinyle (% en poids) | Agent de transfert injecté (% en poids) | Taux de peroxyde (ppm en poids) |
|---|---|---|---|
| Contre-exemple 1 | 28 | 2 | 244 |

Enfin, le contre-exemple 2 est un grade commercial EVATANE® 28800 fourni par la société ARKEMA dont la viscosité Brookfield est supérieure à 25 000 mPa.s. Le taux de comonomère acétate de vinyle est de 28% en poids.

Ces copolymères ont été caractérisés sur rhéomètre Brookfield dans les conditions décrites dans le tableau ci-dessous :

| Conditions de caractérisation de la viscosité Brookfield | |
|---|---|
| Equipement | Rhéomètre Brookfield RV-DVIII |
| Mobile utilisé | SC4-27 ou SC4-29 |
| Température de caractérisation | 120°C |
| Vitesse de rotation du mobile | 20 tours / minute |

Les viscosités Brookfield ainsi mesurées sont reportées dans le tableau ci-dessous :

| Essai | Mobile utilisé | Visco Brookfield à 120°C (mPa.s) |
|---|---|---|
| Exemple 1 | SC4-29 | 13450 |
| Exemple 2 | SC4-29 | 22400 |
| Contre-exemple 1 | SC4-27 | 525 |
| Contre-exemple 2 | SC4-29 | 76000 |

### 2) Préparation de la formulation / additivation :

L'additivation des copolymères par du méthacrylate de 3-triméthoxysilyl propyle (agent de couplage) et par du monoperoxycarbonate de O,O-tertiobutyle et 0-(2-éthylhexyle) (agent de réticulation) a été effectuée par mélange à chaud dans un fondoir régulé à 80°C et agité à la vitesse de 250 tr/min.

Les taux d'additifs sont tels que décrits dans le tableau ci-dessous :

| Produit | Taux dans la formulation (% en poids) |
|---|---|
| Copolymère éthylène/acétate de vinyle | 98,2 |
| Monoperoxycarbonate de O,O-tertiobutyle et O-(2-éthylhexyle) | 1,5 |
| Méthacrylate de 3-triméthoxysilyl propyle | 0,3 |
| Total | 100 |

### 3) Evaluation de la réticulabilité :

Les formulations obtenues ont ensuite été analysées par rhéométrie dynamique à plans parallèles. Le protocole suivi est tel que décrit dans le tableau ci-dessous :

| Protocole d'évaluation de la réticulabilité par rhéométrie à plans parallèles | | |
|---|---|---|
| Rhéomètre | Anton Paar - Modèle MCR 301 | |
| Diamètre des plans | 50 mm | |
| Gap | 1 mm | |
| Amplitude de déformation | 10% | |
| Fréquence d'oscillation | 10Hz | |
| Mode opératoire temps/température | 80°C | Initial |
| | Rampe 80→ 150°C | 14 minutes |
| | Isotherme 150°C | 30 minutes |
| Données obtenues | Courbe d'évolution du module élastique G' (Pa) en fonction du temps t (s) | |
| Critère représentatif du niveau de réticulation | Niveau de module élastique G' après réticulation supérieur ou égal à 10³ Pa à 150°C | |

Les courbes obtenues pour les différentes formulations sont présentées sur la figure 1.

A partir de ces courbes, les niveaux de module élastique G' à 150°C après réticulation ont été obtenus. Ils sont reportés dans le tableau ci-dessous :

| Essai | Niveau de module élastique G' à 150°C après réticulation (Pa) |
|---|---|
| Exemple 1 | 1450 |
| Exemple 2 | 2000 |
| Contre-exemple 1 | 1,05 |
| Contre-exemple 2 | 65800 |

### 4) Mise en oeuvre de l'encapsulant

Les formulations ont été mises en oeuvre par enduction à l'aide d'un applicateur spiralé. Les formulations ont été chauffées à une température de 100°C puis coulées sur un substrat de verre. L'applicateur spiralé a permis ensuite d'étaler chaque formulation en une couche d'épaisseur régulière.

Dans le cas des exemples 1 et 2, ainsi que du contre-exemple 1, l'enduction n'a pas posé de problème et une couche régulière a pu être obtenue. Cependant, compte tenu de la trop faible viscosité du contre-exemple 1, celui-ci ne présente aucune tenue mécanique après refroidissement, et ce même après l'étape de réticulation. Les exemples 1 et 2 présentaient, quant à eux, une bonne applicabilité, combinée à une bonne tenue mécanique après refroidissement. Enfin, le contre-exemple 2, compte-tenu de sa viscosité relativement élevée, ne permettait pas une application par ce procédé d'enduction.

## Revendications

1. Utilisation comme encapsulant dans un module photovoltaïque d'une composition polymérique, ladite composition polymérique comprenant un copolymère qui comprend un monomère d'éthylène et un comonomère d'ester vinylique d'acide carboxylique, le comonomère d'ester vinylique d'acide carboxylique représentant entre 5% et 50% en poids, par rapport au poids total du copolymère, et la composition polymérique ayant une viscosité Brookfield mesurée à 120°C comprise entre 10 000 mPa.s et 25 000 mPa.s.

2. Utilisation selon la revendication 1, **caractérisée en ce que** le comonomère d'ester vinylique d'acide carboxylique est choisi dans le groupe constitué par l'acétate de vinyle, le 2-éthylhexanoate de vinyle, l'octanoate de vinyle et l'ester vinylique de l'acide versatique, et est préférentiellement l'acétate de vinyle.

3. Utilisation selon l'une ou l'autre des revendications 1 et 2, **caractérisée en ce que** le copolymère comprend de 10% à 40%, plus préférentiellement de 15% à 35% en poids de comonomère d'ester vinylique d'acide carboxylique, par rapport au poids total du copolymère.

4. Utilisation selon l'une quelconque des revendications 1 à 3, **caractérisée en ce que** le copolymère est constitué d'un monomère d'éthylène et d'un comonomère d'ester vinylique d'acide carboxylique.

5. Utilisation selon l'une quelconque des revendications 1 à 4, **caractérisée en ce que** le copolymère représente entre 92% et 99,9%, préférentiellement entre 97,5% et 99,5, par rapport au poids total de la composition polymérique.

6. Utilisation selon l'une quelconque des revendications 1 à 5, **caractérisée en ce que** la composition polymérique comprend en outre un agent de réticulation, l'agent de réticulation représentant au total entre 0,1% et 5%, préférentiellement entre 0,5% et 2,5%, plus préférentiellement entre 0,7% et 2% en poids, par rapport au poids total de la composition polymérique.

7. Utilisation selon l'une quelconque des revendications 1 à 6, **caractérisée en ce que** la composition polymérique a une viscosité Brookfield mesurée à 120°C comprise entre 12 000 mPa.s et 23 000 mPa.s.

8. Procédé d'encapsulation d'un module photovoltaïque comprenant les étapes consistant à :
a) se munir d'une composition polymérique comprenant :
- un copolymère comprenant un monomère d'éthylène et un comonomère d'ester vinylique d'acide carboxylique, le comonomère d'ester vinylique d'acide carboxylique représentant entre 5% et 50% en poids, par rapport au poids total du copolymère, et
- un agent de réticulation,
la composition polymérique ayant une viscosité Brookfield mesurée à 120°C comprise entre 10 000 mPa.s et 25 000 mPa.s ;
b) former un empilement comprenant, dans l'ordre, une couche protectrice arrière, une première couche de la composition polymérique, un ensemble de cellules photovoltaïques, une seconde couche de la composition polymérique, et une couche protectrice avant ; puis
c) appliquer un traitement d'activation adapté à l'agent de réticulation pour réticuler la composition.

9. Procédé selon la revendication 8, **caractérisé en ce que** l'agent de réticulation est un agent de réticulation à activation thermique et l'étape c) consiste à traiter thermiquement l'empilement à une température supérieure à la température d'activation de l'agent de réticulation de la composition polymérique.

10. Procédé selon l'une ou l'autre des revendications 8 et 9, **caractérisé en ce qu'**il est mis en oeuvre en continu.

## Patentansprüche

1. Verwendung einer Polymerzusammensetzung als Verkapselungsmittel in einem Photovoltaikmodul, wobei die Polymerzusammensetzung ein Copolymer umfasst, das ein Ethylenmonomer und ein Carbonsäurevinylester-Comonomer umfasst, wobei das Carbonsäurevinylester-Comonomer zwischen 5 % und 50 % nach Gewicht ausmacht, bezogen auf das Gesamtgewicht des Copolymers, und wobei die Polymerzusammensetzung eine Brookfield-Viskosität, gemessen bei 120 °C, im Bereich zwischen 10.000 mPa.s und 25.000 mPa.s hat.

2. Verwendung nach Anspruch 1, **dadurch gekennzeichnet, dass** das Carbonsäurevinylester-Comonomer aus der Gruppe ausgewählt ist, die aus Vinylacetat, Vinyl-2-ethylhexanoat, Vinyloctanoat und Neodecansäure-Vinylester besteht, wobei es sich vorzugsweise um Vinylacetat handelt.

3. Verwendung nach einem beliebigen der Ansprüche 1 und 2, **dadurch gekennzeichnet, dass** das Copolymer 10 % bis 40 %, mit größerem Vorzug 15 % bis 35 % nach Gewicht an Carbonsäurevinylester-Comonomer umfasst, bezogen auf das Gesamtgewicht des Copolymers.

4. Verwendung nach einem beliebigen der Ansprüche 1 bis 3, **dadurch gekennzeichnet, dass** das Copolymer aus einem Ethylenmonomer und einem Carbonsäurevinylester-Comonomer besteht.

5. Verwendung nach einem beliebigen der Ansprüche 1 bis 4, **dadurch gekennzeichnet, dass** das Copolymer zwischen 92 % und 99,9 %, vorzugsweise zwischen 97,5 % und 99,5, ausmacht, bezogen auf das Gesamtgewicht der Polymerzusammensetzung.

6. Verwendung nach einem beliebigen der Ansprüche 1 bis 5, **dadurch gekennzeichnet, dass** die Polymerzusammensetzung darüber hinaus ein Vernetzungsmittel umfasst, wobei das Vernetzungsmittel insgesamt zwischen 0,1% und 5 %, vorzugsweise zwischen 0,5 % und 2,5 %, stärker bevorzugt zwischen 0,7 % und 2 % nach Gewicht ausmacht, bezogen auf das Gesamtgewicht der Polymerzusammensetzung.

7. Verwendung nach einem beliebigen der Ansprüche 1 bis 6, **dadurch gekennzeichnet, dass** die Polymerzusammensetzung eine Brookfield-Viskosität, gemessen bei 120 °C, im Bereich zwischen 12.000 mPa.s und 23.000 mPa.s hat.

8. Verfahren zur Verkapselung eines Photovoltaikmoduls, wobei es die folgenden Schritte umfasst:
a) Bereitstellen einer Polymerzusammensetzung, die Folgendes umfasst:
- ein Copolymer, das ein Ethylenmonomer und ein Carbonsäurevinylester-Comonomer umfasst, wobei das Carbonsäurevinylester-Comonomer zwischen 5 % und 50 % nach Gewicht ausmacht, bezogen auf das Gesamtgewicht des Copolymers, und
- ein Vernetzungsmittel,
wobei die Polymerzusammensetzung eine Brookfield-Viskosität, gemessen bei 120 °C, im Bereich zwischen 10.000 mPa.s und 25.000 mPa.s hat;
b) Bilden einer Aufschichtung, die in der genannten Reihenfolge eine rückseitige Schutzschicht, eine erste Schicht der Polymerzusammensetzung, eine Gesamtheit von Photovoltaik-Zellen, eine zweite Schicht der Polymerzusammensetzung und eine vorderseitige Schutzschicht umfasst; und anschließend
c) Anwenden einer Aktivierungsbehandlung, die für das Vernetzungsmittel geeignet ist, um die Zusammensetzung zu vernetzen.

9. Verfahren nach Anspruch 8, **dadurch gekennzeichnet, dass** es sich bei dem Vernetzungsmittel um ein Vernetzungsmittel mit thermischer Aktivierung handelt und der Schritt c) darin besteht, die Aufschichtung bei einer Temperatur thermisch zu behandeln, die über der Aktivierungstemperatur des Vernetzungsmittels der Polymerzusammensetzung liegt.

10. Verfahren nach einem beliebigen der Ansprüche 8 und 9, **dadurch gekennzeichnet, dass** es kontinuierlich durchgeführt wird.

## Claims

1. The use, as encapsulant in a photovoltaic module, of a polymeric composition, said polymeric composition comprising a copolymer which comprises an ethylene monomer and a carboxylic acid vinyl ester comonomer, the carboxylic acid vinyl ester comonomer representing between 5% and 50% by weight, relative to the total weight of the copolymer, and the polymeric composition having a Brookfield viscosity, measured at 120°C, of between 10 000 mPa.s and 25 000 mPa.s.

2. The use as claimed in claim 1, **characterized in that** the carboxylic acid vinyl ester comonomer is chosen from the group consisting of vinyl acetate, vinyl 2-ethylhexanoate, vinyl octanoate and versatic acid vinyl ester, and is preferentially vinyl acetate.

3. The use as claimed in either of claims 1 and 2, **characterized in that** the copolymer comprises from 10% to 40%, more preferentially from 15% to 35% by weight of carboxylic acid vinyl ester comonomer, relative to the total weight of the copolymer.

4. The use as claimed in any one of claims 1 to 3, **characterized in that** the copolymer consists of an ethylene monomer and of a carboxylic acid vinyl ester comonomer.

5. The use as claimed in any one of claims 1 to 4, **characterized in that** the copolymer represents between 92% and 99.9%, preferentially between 97.5% and 99.5%, relative to the total weight of the polymeric composition.

6. The use as claimed in any one of claims 1 to 5, **characterized in that** the polymeric composition also comprises a crosslinking agent, the crosslinking agent representing in total between 0.1% and 5%, preferentially between 0.5% and 2.5%, more preferentially between 0.7% and 2% by weight, relative to the total weight of the polymeric composition.

7. The use as claimed in any one of claims 1 to 6, **characterized in that** the polymeric composition has a Brookfield viscosity, measured at 120°C, of between 12 000 mPa.s and 23 000 mPa.s.

8. A process for encapsulating a photovoltaic module, comprising the steps consisting in:
a) obtaining a polymeric composition comprising:
- a copolymer comprising an ethylene monomer and a carboxylic acid vinyl ester comonomer, the carboxylic acid vinyl ester comonomer representing between 5% and 50% by weight, relative to the total weight of the copolymer, and
- a crosslinking agent,
the polymeric composition having a Brookfield viscosity, measured at 120°C, of between 10 000 mPa.s and 25 000 mPa.s;
b) forming a stack comprising, in order, a protective backsheet, a first layer of the polymeric composition, an assembly of photovoltaic cells, a second layer of the polymeric composition, and a protective front sheet; then
c) applying an activation treatment suitable for the crosslinking agent in order to crosslink the composition.

9. The process as claimed in claim 8, **characterized in that** the crosslinking agent is a thermally activated crosslinking agent and step c) consists in heat treating the stack at a temperature above the activation temperature of the agent for crosslinking the polymeric composition.

10. The process as claimed in either of claims 8 and 9, **characterized in that** it is carried out continuously.
